# EUROPÄISCHE PATENTSCHRIFT

(11) **EP 1 189 350 B1**
(45) Veröffentlichungstag und Bekanntmachung des Hinweises auf die Patenterteilung: **08.04.2009**
(21) Anmeldenummer: 01119171.5
(22) Anmeldetag: 08.08.2001
(51) Int. Cl.: H03K 17/18

(54) **Schaltungsanordnung und Anzeigeelement**
Circuit arrangement and indicating element
Montage et élément indicateur

(30) Priorität: 10.08.2000 DE 10038969
(43) Veröffentlichungstag der Anmeldung: 20.03.2002
(73) Patentinhaber: Infineon Technologies AG, 81669 München (DE)
(72) Erfinder: Gergintschew, Zenko, 81379 München (DE)
(74) Vertreter: Patentanwälte Westphal, Mussgnug & Partner

(56) Entgegenhaltungen:
- DE-A- 2 524 084
- US-A- 3 034 112
- US-A- 3 987 401
- US-A- 4 394 647
- ANONYMOUS: "Tri-colored LED shows state of tri-state driver" RESEARCH DISCLOSURE, KENNETH MASON PUBLICATIONS, HAMPSHIRE, GB, Bd. 294, Nr. 83, Oktober 1988 (1988-10), XP007113050 ISSN: 0374-4353
- KLEINE G: "MAINS PULSER" ELEKTOR ELECTRONICS, ELEKTOR PUBLISHERS LTD. CANTERBURY, GB, Bd. 24, Nr. 272, Dezember 1998 (1998-12), Seite 73 XP000889333 ISSN: 0268-4519
- PATENT ABSTRACTS OF JAPAN vol. 018, no. 063 (E-1500), 2. Februar 1994 (1994-02-02) -& JP 05 282989 A (SONY CORP), 29. Oktober 1993 (1993-10-29)

## Beschreibung

Die Erfindung betrifft eine Schaltungsanordnung mit einem integrierten Halbleiterelement und einem Anzeigeelement. Die Erfindung betrifft ferner ein integriertes Anzeigeelement zur Diagnose und Anzeige einer Störung bei einem Halbleiterelement.

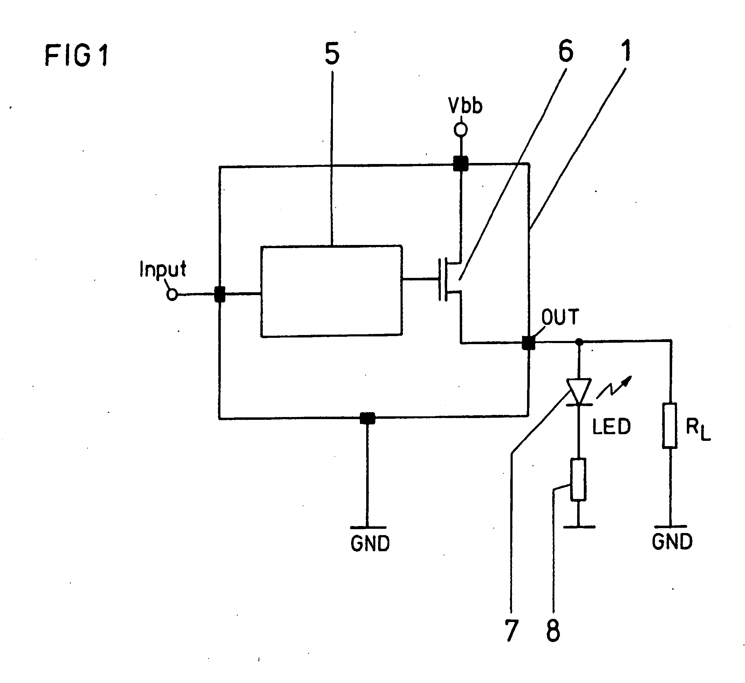

Leistungsschalter auf Halbleiterbasis, wie zum Beispiel intelligente Leistungshalbleiter ("Smart Power Switches"), die zum Treiben einer Last verwendet werden, können mit Anzeigeelementen zur Anzeige des Schaltzustandes, zum Beispiel "AN" oder "AUS", ausgestattet sein. Ein allgemein bekanntes Beispiel für eine solche Schaltungsanordnung zum Anzeigen des Schaltzustandes ist in Figur 1 dargestellt. In der dargestellten, allgemein bekannten Schaltungsanordnung zur Anzeige einer Diagnoseinformation wird an den Ausgang der Leistungsstufe eine in grüner Farbe leuchtende, lichtemittierende Diode (LED) mit einem Vorwiderstand parallel zur Last angeordnet.

Des weiteren sind intelligente Leistungshalbleiter, wie etwa die von der Firma Infineon Technologies AG vertriebenen PRO-FET-Chips, bekannt, die Diagnoseausgänge zur Ausgabe von Diagnosefunktionen aufweisen. Auszugebende Informationen können beispielsweise das Auftreten eines Kurzschlusses, von Übertemperatur der Leistungsstufe, eines Lastabrisses oder dergleichen sein.

Nachteil bekannter intelligenter Leistungshalbleiter mit Diagnoseausgang ist, dass die Anzeige der Art der zu diagnostizierenden Information eine vergleichsweise hohe Anzahl elektronischer Bauelemente erfordert, die mit dem intelligenten Halbleiterelement verbunden werden müssen.

Anonymous: "Tri-colored LED shows state of tri-state driver" RESEARCH DISLOSURE, KENNETH MASON PUBLICATIONS, HAMPSHIRE, GB, Bd. 294, Nr. 83, Oktober 1988 (1988-10), Apo07113050 ISSN: 0374-4353, beschreibt eine Schaltungsanordnung mit einem Treiber und mit einer an den Ausgang des Treibers angeschlossenen Leuchtdiodenanordnung, die zwei antiparallel geschaltetete Leuchtdioden unterschiedlicher Farbe aufweist.

Der Erfindung liegt die Aufgabe zugrunde, den schaltungstechnischen Aufwand, der zum Anzeigen der Diagnosefunktion in Halbleiterelementen erforderlich ist, zu reduzieren.

Diese Aufgabe wird erfindungsgemäß gelöst durch eine Schaltungsanordnung mit den Merkmalen des Patentanspruchs 1.

Gemäß Patentanspruch 1 ist eine Schaltungsanordnung vorgesehen, mit einem integrierten Halbleiterelement, das eine Leistungsstufe zum Schalten einer Last, eine Stromquelle und eine Stromsenke, die mit einem einzigen Diagnoseausgang verbunden sind und die einen Strom am Diagnoseausgang bereitstellen, und ein Ansteuerschaltung zur Steuerung der Leistungsstufe und/oder der Stromquelle und Stromsenke aufweist, mit einem Anzeigeelement, das einen ersten Anschluss aufweist, der elektrisch mit dem Diagnoseausgang des Halbleiterelementes verbunden ist, das einen zweiten Anschluss aufweist, der elektrisch mit dem Lastausgang der Leistungsstufe verbunden ist und das antiparallel geschaltete, lichtemittierende Halbleiterdioden enthält, die nach Maßgabe des ihnen zugeführten Stromes unterscheidbare, visuelle Informationen an ihre Umgebung abgegeben.

Im Halbleiterelement sind je nach Art der gewünschten Informationsvielfalt entweder eine oder mehrere Stromquellen bzw. Stromsenken integriert. Durch die Verwendung von Stromquellen oder -senken können die Anzeigeelemente, welche beispielsweise LEDs sein können, direkt elektrisch gespeist werden.

Gemäß der Erfindung erfolgt die elektrische Verbindung zum Anzeigeelement über genau eine Leitung. Die Diagnosefunktion ist erzielbar ohne dass zusätzliche elektrische Bauelemente zur Beschaltung des Anzeigeelements benötigt werden.

Handelt es sich bei dem eingesetzten Halbleiterelement um ein Halbleiterelement mit integrierter Logik bzw. mit Ansteuerschaltung, so ist es zweckmäßig, dass die Stromquelle oder Stromsenke und/oder die Leistungsstufe von der Logik angesteuert werden.

In einer vorteilhaften Weiterbildung gibt die Stromstärke und Stromflussrichtung des von der Stromquelle und Stromsenke am Diagnoseausgang bereitstellten Stromes eine Informationen über den Status der Leistungsstufe, der mit der Leistungsstufe verbundenen Last oder des Halbleiterelement. Die Stromquelle und Stromsenke sind hierzu mit mindestens einem Diagnoseausgang des Halbleiterelements elektrisch leitfähig verbunden. Der Diagnoseausgang dient zum Signalisieren einer Information über den Status der Schaltungsanordnung und/oder einer mit dem Halbleiterelement verbundenen Last. Als Statusinformationen können beispielsweise vorgesehen sein:
1. Das Halbleiterelement bzw. die Leistungsstufe arbeiten im Normalbetrieb.
2. Das Halbleiterelement bzw. die Leistungsstufe sind ausgeschaltet.
3. Das Halbleiterelement bzw. die Leistungsstufe und/oder die daran angeschlossene Last weist einen Fehler, eine Störung, eine Fehlfunktion oder einen Funktionsausfall auf.
Daneben könnten natürlich noch weitere Statusinformationen denkbar sein.

In einer schaltungstechnisch typischen Ausgestaltung sind die Stromquelle und die Stromsenke in Halbbrückenanordnung zueinander angeordnet, wobei der Mittelabgriff der Halbbrücke mit dem Diagnoseausgang verbunden ist. Vorteilhafterweise sind die Stromquelle und/oder Stromsenke als MOSFET ausgebildet sind.

Das Halbleiterelement weist typischerweise neben dem Diagnoseausgang auch einen Eingangsanschluss, einen mit der Last verbundenen Ausgangsanschluss und mindestens einen Versorgungsanschluss für ein Versorgungspotential auf. Neben den Anschlüssen für die Diagnose, für den Eingang, für den Ausgang weist das Diagnoseelement typischerweise mindestens einen Anschluss für ein Versorgungspotential auf.

Mit dem Eingangsanschluss des Halbleiterelements ist bevorzugt zumindest eine der vorstehend erwähnten Stromquellen oder Stromsenken unmittelbar, d. h. direkt elektrisch leitfähig verbunden.

In einer sehr vorteilhaften Ausgestaltung ist die Leistungestufe als Low-Side-Schalter ausgebildet. Das Halbleiterelement weist dann lediglich einen einzigen Versorgungsanschluss, an dem ein erstes Versorgungspotential anliegt, auf. Ein zweites Versorgungspotential wird hier über den Ausgangsanschluss, der mit der Last verbunden ist, eingekoppelt. Auf diese Weise kann auf einen Anschluss des Halbleiterelementes verzichtet werden.

Gemäß einer weiteren bevorzugten Ausführungsform der Erfindung ist das Halbleiterelement mit einer Last verbunden, deren erster Anschluss mit einem negativen Versorgungspotential verbunden ist. Die Laststrecke des Halbleiterelementes ist zwischen einem positiven Versorgungspotential und dem Lastausgang angeordnet. Derartige Anordnungen sind auch als High-Side-Schalter bekannt.

Bei der Leistungsstufe handelt es sich vorzugsweise um ein Leistungshalbleiterbauelement. Das Leistungshalbleiterbauelement ist vorzugsweise als Leistungs-MOSFET oder als IGBT ausgebildet ist, da sich diese Bauelemente zum Schalten hoher Ströme und/oder Spannungen besonders gut eignen.

Weitere vorteilhafte Ausgestaltungen und Weiterbildungen der Erfindung sind den Unteransprüchen, der folgenden Beschreibung und den Figuren entnehmbar.

Die Erfindung wird nachfolgend anhand der in den Figuren der Zeichnung angegebenen Ausführungsbeispiele näher erläutert. Es zeigt dabei:
- Figur 1: ein Schaltungsanordnung und ein Halbleiterelement mit Diagnoseeinrichtung nach dem Stand der Technik;
- Figur 2: ein erstes Ausführungsbeispiel eines erfindungsgemäßen Halbleiterelements mit Diagnoseeinrichtung und daran angeschlossenem Diagnoseelement (High-Side-Schalter);
- Figur 3: ein zweites Ausführungsbeispiel eines erfindungsgemäßen Halbleiterelements mit Diagnoseelement (Low-Side-Schalter).

In allen Figuren der Zeichnung sind gleiche bzw. funktionsgleiche Elemente mit gleichen Bezugszeichen versehen.

Bei der Schaltungsanordnung nach dem Stand der Technik in Figur 1 ist ein integrierter intelligenter Leistungshalbleiter 1 (Smart Power Switch) mit einem Anzeigeelement 7 für die Diagnose verbunden. Der Leistungshalbleiter 1 umfasst ein Logikelement 5 und ein mit dem Logikelement 5 verbundenen Leistungsschalter 6 (z. B. ein MOSFET). Ferner weist der Leistungshalbleiter Anschlüsse für ein Versorgungspotential Vbb, für den Ausgang OUT und für ein Bezugspotential GND auf. Der Ausgang OUT ist an eine Last R_{L} angeschlossen. Parallel zur Last R_{L} ist ein Anzeigeelement 7 geschaltet, welches im Allgemeinen mit einem Vorwiderstand 8 angepasst werden muss.

Im Betrieb der Schaltungsanordnung nach dem Stand der Technik signalisiert das Anzeigeelement 7 den Schaltzustand des Leistungshalbleiters 1. Ist der Leistungsschalter 6 im eingeschalteten Zustand, so leuchtet das Anzeigeelement. Im umgekehrten Fall, wenn sich der Leistungsschalter im ausgeschalteten Zustand befindet, leuchtet das Anzeigeelement nicht. Bei der Schaltungsanordnung nach Figur 1 kann eine Fehlfunktion des Leistungshalbleiters 1 nicht signalisiert werden.

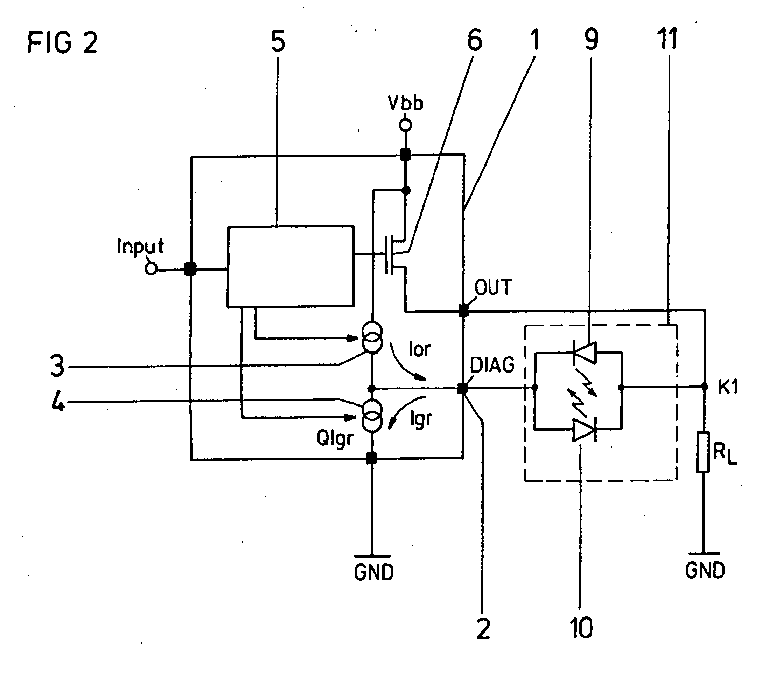

Die Schaltungsanordnung in Figur 2 zeigt ein Beispiel gemäß der Erfindung mit einem intelligenten Leistungshalbleiter 1 und einem mit dem Leistungshalbleiter verbundenen Anzeigeelement 11. Der Leistungshalbleiter 1 umfasst ein Logikelement 5 und ein mit dem Logikelement 5 verbundenen MOSFET 6. Weiterhin sind Anschlüsse für ein Versorgungspotential Vbb, für den Ausgang OUT und für ein Bezugspotential GND vorgesehen. An Ausgang OUT ist die Last R_{L} angeschlossen, wobei erfindungsgemäß ein Knoten K1 für den Anschluss eines Anzeigeelements 11 vorgesehen ist. Das Anzeigeelement 11 wird nach der Erfindung direkt mit einem zusätzlich vorgesehenen Diagnoseausgang DIAG des Halbleiterelements verbunden, so dass sich eine volle H-Brücke ergibt. Der Diagnoseausgang DIAG wird von einer Stromquelle 3 und einer Stromsenke 4 versorgt, so dass ein Vorwiderstand für das Anzeigeelement 11 nicht mehr benötigt wird. Die als Halbbrücke verschaltete Stromquelle 3 und die Stromsenke 4 werden von dem Logikelement 5 angesteuert. Der erste Anschluss der Stromquelle 3 ist mit dem Versorgungspotential Vbb verbunden. Der zweite Anschluss der Stromquelle 3 führt zum Diagnoseausgang DIAG und zum ersten Anschluss der Stromsenke 4. Der zweite Anschluss der Stromsenke 4 ist mit dem Masseanschluss GND verbunden.

Das Anzeigeelement 11 umfasst zwei antiparallel geschaltete LED: eine grün leuchtende LED 9 und eine orange leuchtende LED 10. Das Anzeigeelement 11 weist zwei Klemmen auf, mit denen die Funktionen des Anzeigeelementes 11 aktiviert werden können. Die erste Klemme ist mit Diagnoseausgang DIAG verbunden. Die zweite Klemme ist mit Knotenpunkt K1 verbunden.

Im Betrieb der Schaltungsanordnung schaltet das Anzeigeelement 11 in Abhängigkeit der Richtung des durch das Anzeigeelement 11 fließenden Stroms die vorgesehenen Signalzustände. Wenn kein Strom fließt, bleiben beide LEDs 9, 10 aus. Wird Stromquelle 3, z. B. bei Auftreten eines Kurzschlusses, aktiviert, fließt ein Strom Ior von Klemme DIAG zum Knoten K1. Das Anzeigeelement 11, bzw. die LED 10, leuchtet orange. Fließt der Strom Igr bei aktivierter Stromsenke 4 in umgekehrter Richtung, leuchtet das Anzeigeelement 11, bzw. die LED 9, grün. Hierdurch kann beispielsweise der Normalbetrieb angezeigt werden. Die Schaltzustände werden vom Logikelement 5 bestimmt, so dass neben dem Status der Last R_{L} auch eine Fehlfunktion des Leistungshalbleiters 1 signalisiert werden kann. Im Kurzschlussfall wird der Knoten K1 auf ein niedriges Potential gezogen und der Strom für die orange Leuchtdiode 10 kann über Stromquelle 3 vom positiven Versorgungpotential Vbb über die Leuchtdiode gegen Anschluss GND fließen. Die Schaltungsanordnung gemäß Figur 2 ist somit als High-Side-Schalter ausgebildet.

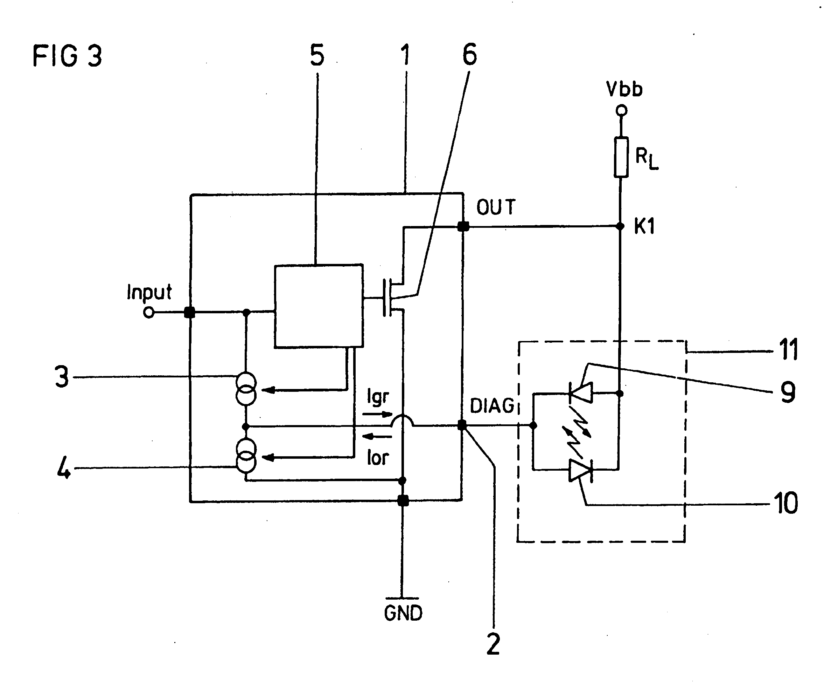

In Figur 3 ist ein weiteres erfindungsgemäßes Beispiel für eine Schaltungsanordnung und für einen möglichen Aufbau eines erfindungsgemäßen intelligenten Leistungshalbleiters 1 gezeigt. Das Anzeigeelement 11 entspricht der in Figur 2 dargestellten Ausführungsform. Der Leistungshalbleiter mit Logikelement 5 steuert ein Treiberelement 6 an, welches beispielsweise ein MOSFET ist. Das Logikelement des intelligenten Leistungshalbleiters erhält von außen über den Eingang Input Ansteuersignale für den gewünschten Schaltzustand des Treiberelementes 6.

Nach der Ausführungsform von Figur 3 kann ein Anschluss für das Versorgungspotential Vbb entfallen. Hierzu ist Ausgang OUT an die Seite der Last R_{L} mit vermindertem Ausgangspotential über Knotenpunkt K1 angeschlossen. Die Last R_{L} wird direkt an das positive Versorgungspotential Vbb angeschlossen. Von Knotenpunkt K1 besteht eine weitere Verbindung zum zweiten Anschluss des Anzeigeelements 11. Die erste Klemme des Anzeigeelements 11 ist dem Diagnoseausgang DIAG des Halbleiterelements verbunden. Der Diagnoseausgang DIAG wird wie in Figur 3 von einer Stromquelle 3 und Stromsenke 4 versorgt. Die Stromquelle 3 und die Stromsenke 4 werden ebenfalls wie in Figur 3 von dem Logikelement 5 angesteuert. Der erste Anschluss der Stromquelle 3 ist mit dem Eingang Input unmittelbar verbunden. Der zweite Anschluss der Stromquelle 3 führt zum Diagnoseausgang DIAG und zum ersten Anschluss der Stromsenke 4. Der zweite Anschluss der Stromsenke 4 ist mit dem Anschluss GND verbunden.

Die Schaltungsanordnung von Figur 3 ist als "Low-Side"-Schalter ausgeführt was vorteilhafterweise zu einer Einsparung eines Spannungsversorgungsanschlusses Vbb führt.

Das vorliegende erfindungsgemäße Halbleiterelement mit Diagnoseeinrichtung, das Diagnoseelement und die Schaltungsanordnung zur Diagnose wurden anhand der vorstehenden Beschreibung so dargelegt, um das Prinzip der Erfindung und dessen praktische Anwendung am besten zu erklären. Selbstverständlich lässt sich die erfindungsgemäße Anordnung im Rahmen des fachmännischen Handelns in mannigfaltiger Art und Weise abwandeln.

## Patentansprüche

1. Schaltungsanordnung
mit einem integrierten Halbleiterelement (1), das
eine Leistungsstufe (6) zum Schalten einer Last (R_{L}), eine Stromquelle (3) und eine Stromsenke (4), die mit einem einzigen Diagnoseausgang (2) verbunden sind und die einen Strom (Igr, Ior) am Diagnoseausgang (2) bereitstellen, und
ein Ansteuerschaltung (5) zur Steuerung der Leistungstufe (6) und/oder der Stromquelle (3) und Stromsenke (4) aufweist,
mit einem Anzeigeelement (11),
das einen ersten Anschluss (DIAG) aufweist, der elektrisch mit dem Diagnoseausgang (2) des Halbleiterelementes (1) verbunden ist,
das einen zweiten Anschluss (K1) aufweist, der elektrisch mit dem Lastausgang (OUT) der Leistungsstufe (6) verbunden ist, und
das antiparallel geschaltete, lichtemittierende Halbleiterdioden (9, 10) enthält, die nach Maßgabe des ihnen zugeführten Stromes (Igr, Ior) unterscheidbare, visuelle Informationen an ihre Umgebung abgegeben.

2. Schaltungsanordnung nach Anspruch 1,
**dadurch gekennzeichnet,**
**dass** die Stromstärke und Stromflussrichtung des von der Stromquelle (3) und Stromsenke (4) am Diagnoseausgang (2) bereitgestellten Stromes (Igr, Ior) eine Information über den Status der Leistungsstufe (6), der mit der Leistungsstufe (6) verbundenen Last (R_{L}) oder des Halbleiterelement (1) geben.

3. Schaltungsanordnung nach einem der vorstehenden Ansprüche,
**dadurch gekennzeichnet**,
das die Stromquelle (3) und Stromsenke (4) in Halbbrückenanordnung zueinander angeordnet sind, wobei der Mittelabgriff der Halbbrückenanordnung mit dem Diagnoseausgang (2) verbunden ist.

4. Schaltungsanordnung nach einem der vorstehenden Ansprüche,
**dadurch gekennzeichnet,**
**dass** die Stromquelle (3) und/oder die Stromsenke (4) als MOSFET ausgebildet sind.

5. Schaltungsanordnung nach einem der vorstehenden Ansprüche,
**dadurch gekennzeichnet,**
**dass** das Halbleiterelement (1) neben dem Diagnoseausgang (2) einen Eingangsanschluss (Input), einen mit der Last (R_{L}) verbundenen Ausgangsanschluss (OUT) und mindestens einen Versorgungsanschluss für ein Versorgungspotential (Vbb, GND) aufweist.

6. Schaltungsanordnung nach einem der vorstehenden Ansprüche,
**dadurch gekennzeichnet,**
**dass** das Halbleiterelement (1) als Low-Side-Schalter ausgebildet ist und lediglich einen einzigen Versorgungsanschluss, an dem ein erstes Versorgungspotential (GND) anliegt aufweist und ein zweites Versorgungspotential (Vbb) über den Ausgangsanschluss (OUT) einkoppelbar ist.

7. Schaltungsanordnung nach Anspruch 6,
**dadurch gekennzeichnet,**
**dass** die Stromquelle (3) und/oder die Stromsenke (4) mit dem Eingangsanschluss (Input) direkt elektrisch leitfähig verbunden ist.

8. Schaltungsanordnung nach einem der vorstehenden Ansprüche,
**dadurch gekennzeichnet,**
**dass** die Leistungsstufe (6) als Leistungshalbleiterbauelement, insbesondere als Leistungs-MOSFET (6) oder als IGBT, ausgebildet ist.

## Claims

1. Circuit arrangement
having
an integrated semiconductor element (1) which has a power stage (6) for switching a load (R_{L}), a current source (3) and a current sink (4), which are connected to a single diagnostic output (2) and which provide a current (Igr, Ior) at the diagnostic output (2), and a drive circuit (5) for controlling the power stage (6) and/or the current source (3) and current sink (4), and
having
a display element (11), which has a first terminal (DIAG), which is electrically connected to the diagnostic output (2) of the semiconductor element (1),
which has a second terminal (K1) which is electrically connected to the load output (OUT) of the power stage (6), and
which contains light-emitting semiconductor diodes (9, 10) which are connected in antiparallel and output to their environment visual information items which can be distinguished in accordance with the current (Igr, Ior) fed to them.

2. Circuit arrangement according to Claim 1,
**characterized in that**
the intensity and flow direction of the current (Igr, Ior) supplied at the diagnostic output (2) by the current source (3) and current sink (4) provide an item of information on the status of the power stage (6), the load (R_{L}) connected to the power stage (6) or the semiconductor element (1).

3. Circuit arrangement according to one of the preceding claims,
**characterized in that**
the current source (3) and current sink (4) are arranged in a half-bridge arrangement relative to one another, the centre tap of the half-bridge arrangement being connected to the diagnostic output (2).

4. Circuit arrangement according to one of the preceding claims,
**characterized in that**
the current source (3) and/or the current sink (4) are/is designed as MOSFETs.

5. Circuit arrangement according to one of the preceding claims,
**characterized in that**
in addition to the diagnostic output (2), the semiconductor element (1) has an input terminal (Input), an output terminal (OUT) connected to the load (R_{L}), and at least one supply terminal for a supply potential (Vbb, GND).

6. Circuit arrangement according to one of the preceding claims,
**characterized in that**
the semiconductor element (1) is designed as a low-side switch and has only a single supply terminal, at which a first supply potential (GND) is present, and a second supply potential (Vbb) can be impressed via the output terminal (OUT).

7. Circuit arrangement according to Claim 6,
**characterized in that**
the current source (3) and/or the current sink (4) are/is connected to the input terminal (Input) in a fashion directly capable of electric conduction.

8. Circuit arrangement according to one of the preceding claims,
**characterized in that**
the power stage (6) is designed as a power semiconductor component, in particular as a power MOSFET (6) or as an IGBT.

## Revendications

1. Circuit
comprenant un élément (1) à semi-conducteur intégré, qui a
un étage (6) de puissance pour le montage d'une charge (R_{L}),
une source (3) de courant et un puits (4) de courant qui sont reliés à une sortie (2) unique de diagnostic et qui procurent un courant (Igr, Ior) à la sortie (2) de diagnostic, et
un circuit (5) de commande de l'étage (6) de puissance et/ou de la source (3) de courant et du puits (4) de courant
comprenant un élément (11) indicateur,
qui a une première borne (DIAG), reliée électriquement à la sortie (2) de diagnostic de l'élément (1) semi-conducteur,
qui a une deuxième borne (K1) reliée électriquement à la sortie (OUT) de charge de l'étage (6) de puissance,
qui comporte des diodes (9, 10) à semi-conducteurs électroluminescentes montées tête-bêche qui, suivant l'intensité du courant (Igr, Ior) qui leur est apportée, donnent à ce qui les entoure des informations visuelles pouvant être distinguées.

2. Circuit électrique suivant la revendication 1,
**caractérisé,**
**en ce que** l'intensité et la direction de flux du courant (Igr, Ior) procurées par la source (3) de courant et par le puits (4) de courant à la sortie (2) de diagnostic donnent une information sur le statut de l'étage (6) de puissance de la charge (R_{L}) reliée à l'étage (6) de puissance ou de l'élément (1) à semi-conducteur.

3. Circuit électrique suivant l'une des revendications précédentes,
**caractérisé,**
**en ce que** la source (3) de courant et le puits (4) de courant sont montés l'un par rapport à l'autre, suivant un montage en demi-pont, la prise médiane du montage en demi-pont étant reliée à la sortie (2) de diagnostic.

4. Circuit électrique suivant l'une des revendications précédentes,
**caractérisé en ce que** la source (3) de courant et/ou le puits (4) de courant sont constitués sous la forme de MOSFET.

5. Circuit électrique suivant l'une des revendications précédentes,
**caractérisé,**
**en ce que** l'élément (1) à semi-conducteur a, outre la sortie (2) de diagnostic, une borne (Input) d'entrée, une borne (OUT) de sortie reliée à la charge (R_{L}) et au moins une borne d'alimentation pour un potentiel (Vbb, GND) d'alimentation.

6. Circuit électrique suivant l'une des revendications précédentes,
**caractérisé,**
**en ce que** l'élément (1) à semi-conducteur est constitué sous la forme d'un commutateur Low-Side et a seulement une borne unique d'alimentation, auquel s'applique un premier potentiel (GND) d'alimentation et un deuxième potentiel (Vbb) d'alimentation peut être appliqué par la borne (OUT) de sortie.

7. Circuit électrique suivant la revendication 6,
**caractérisé**
**en ce que** la source (3) et/ou le puits (4) de courant est relié d'une manière conductrice de l'électricité directement à la borne (Input) d'entrée.

8. Circuit électrique suivant l'une des revendications précédentes,
**caractérisé**
**en ce que** l'étage (6) de puissance est constitué en composant à semi-conducteur de puissance, notamment en MOSFET (6) de puissance ou en IGBT.
